# EUROPEAN PATENT APPLICATION

(11) **EP 2 587 910 A1**
(43) Date of publication of application: **01.05.2013**
(21) Application number: 11800850.7
(22) Date of filing: 28.06.2011
(51) Int. Cl.: H05K 9/00, G02B 6/42, H05K 1/18

(54) **ELECTRONIC COMPONENT**

(30) Priority: 28.06.2010 JP 2010146285
(71) Applicant: Yazaki Corporation, Minato-ku Tokyo 108-8333 (JP)
(72) Inventor: MIYAKAWA, Daisuke, Shizuoka 410-1107 (JP)
(74) Representative: Grünecker, Kinkeldey, Stockmair & Schwanhäusser
(86) International application number: PCT/JP2011/064805
(87) International publication number: WO 2012/002386

(57) **Abstract**

To provide an electronic component capable of ensuring precision in a position of a grounding connection portion of a shield case.

In an optical connector 1 including an electronic component body 2 and a shield case 20 which is put on the electronic component body 2 from a case opening 20a side and is thus disposed on an outer periphery of the electronic component body 2, and has ground pins 25a and 26a protruded downward from the case opening 20a, the shield case 20 is provided with position controlled portions 27 and 28 and the electronic component body 2 is provided with position controlling portions 10 and 11 for controlling the position controlled portions 27 and 28 into proper positions.

## Description

### <TECHNICAL FIELD>

The present invention relates to an electronic component having a shield case.

### <BACKGROUND ART>

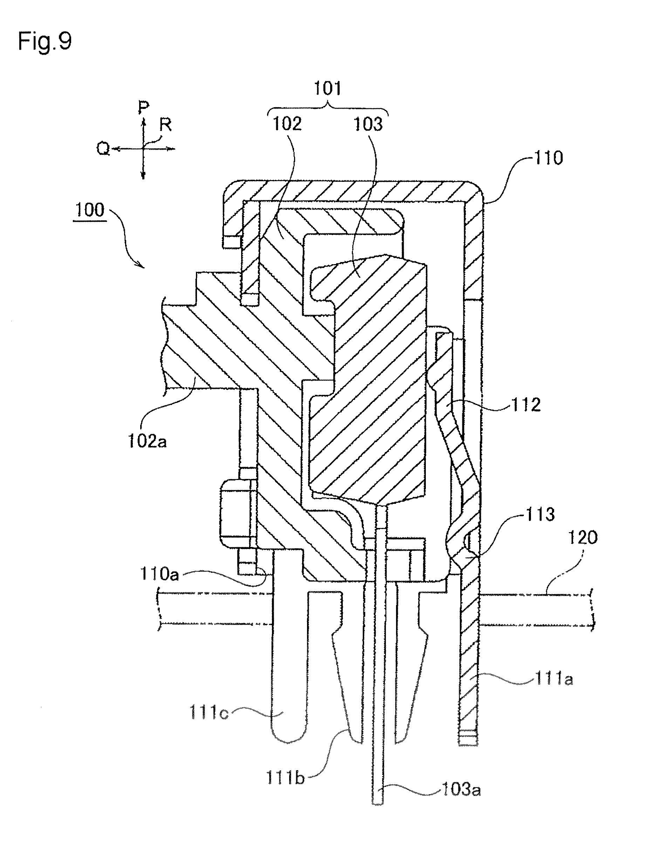

An electronic component of this type according to the conventional example is disclosed in Patent Document 1. An optical connector 100 to be the electronic component includes an electronic component body 101 and a shield case 110 for covering an outer periphery of the electronic component body 101 as shown in Fig. 9. The electronic component body 101 includes a housing 102 having an optical fiber connecting cylinder portion 102a, and a pair of optical transceivers (FOT : Fiber Optical Transceiver) 103 disposed on a rear surface of the housing 102. A front part of the optical fiber connecting cylinder portion 102a is protruded from the shield case 110. A rear end surface of the optical fiber connecting cylinder portion 102a is opposed to the pair of optical transceivers 103 in a close position.

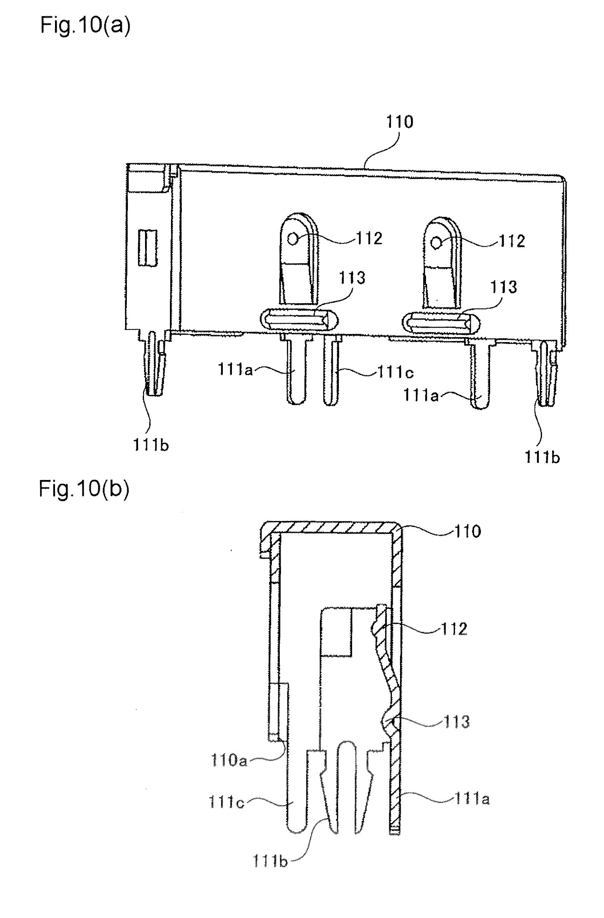

The shield case 110 takes a shape of a box in which a lower surface side is set to be a case opening 110a as shown in detail in Figs. 10(a) and 10(b). The shield case 110 is put on the electronic component body 101 from the case opening 110a side and is thus disposed on the outer periphery of the electronic component body 101. The shield case 110 is provided with ground pins 111a to 111c to be grounding connection portions which are protruded downward from the case opening 110a. A pair of left and right pressing portions 112 is provided on a rear surface of the shield case 110. A stress handling portion 113 is provided below each of the pressing portions 112 of the shield case 110. Each stress handling portion 113 takes a shape of a protruded portion which is protruded toward an inner surface side, and distributes, absorbs or relieves the stress transmitted from the pressing portion 112.

Each of the ground pins 111a to 111c is connected to a predetermined conductor portion (not shown) of a substrate 120 together with a lead portion 103a of the optical transceiver 103 by soldering or the like.

In the conventional example, an electromagnetic wave emitted from each optical transceiver 103 to an outside and an electromagnetic wave incident on the optical transceiver 103 from the outside are shielded by the shield case 110. Therefore, it is possible to prevent a bad influence from being caused by the electromagnetic wave as greatly as possible. Moreover, the stress transmitted from the pressing portion 112 holding the optical transceiver 103 is distributed and absorbed by the stress handling portion 113. Therefore, it is possible to prevent a deformation on a lower side of the shield case 110 from being caused by the stress, thereby inhibiting a change in a position of the ground pin 111a.

### <PRIOR ART DOCUMENT>

### <PATENT DOCUMENT>

Patent Document 1 : JP-A-2008-52153 Publication

### <SUMMARY OF THE INVENTION>

### <PROBLEMS TO BE SOLVED BY THE INVENTION>

In the optical connector 100 according to the conventional example, however, the shield case 110 is simply put on the outer periphery of the electronic component body 101. When an external force in an outward opening direction (an external force which is not caused by the pressing portion 112) acts on the rear surface of the shield case 110 for some reason, therefore, the position of the rear surface of the shield case 110 is easily changed in the outward opening direction. When the portion of the rear surface of the shield case 110 is changed in the outward opening direction, the position of the ground pin 111a on the rear surface of the shield case 110 is changed from a normal position. For this reason, there is a problem in that precision in the position of the ground pin 111a of the shield case 110 cannot be ensured. If the precision in the position of the ground pin 111 a of the shield case 110 is deteriorated, there is a fear that an interference with other components on the substrate 120 might be caused in substrate mounting. Consequently, there is a possibility that a smooth substrate mounting work cannot be carried out.

Therefore, the invention has been made to solve the problem and has an object to provide an electronic component capable of ensuring precision in a position of a grounding connection portion of a shield case.

### <MEANS FOR SOLVING THE PROBLEMS>

The object of the invention can be achieved by the following structures.
(1) An electronic component including an electronic component body and a shield case which is put on the electronic component body from a case opening side and is thus disposed on an outer periphery of the electronic component body, and has a grounding connection portion protruded downward from the case opening, wherein the shield case is provided with a position controlled portion and the electronic component body is provided with a position controlling portion for controlling the position controlled portion into a proper position.

(2) The electronic component having the structure of (1), wherein the position controlling portion controls an outward opening direction of a surface of the shield case provided with the grounding connection portion and a transverse direction of the surface of the shield case provided with the grounding connection portion.

(3) The electronic component having the structure of (1) or (2), wherein one of the surfaces of the shield case is divided into a plurality of divided case piece portions and the divided case piece portions are provided with the grounding connection portion, and the position controlled portion and the position controlling portion are disposed in the divided case piece portions provided with the grounding connection portion respectively.

(4) The electronic component described in any of (1) to (3), wherein the electronic component body includes a housing, an electronic element, and an electronic element cover attached to the housing for fixing the electronic element to the housing, and the electronic element cover is provided with the position controlling portion.

### <BRIEF DESCRIPTION OF THE DRAWINGS>

Fig. 1 is a perspective view showing an embodiment according to the invention as seen from a front surface side of an optical connector.
Fig. 2 is a perspective view showing the embodiment according to the invention as seen from a rear surface side of the optical connector.
Fig. 3 is an exploded perspective view showing the embodiment according to the invention as seen from the front surface side of the optical connector.
Fig. 4 is an A - A line sectional view of Fig. 2 according to the embodiment of the invention.
Fig. 5(a) is a perspective view showing a main part immediately before an attachment of an electronic element cover according to the embodiment of the invention and Fig. 5(b) is a side view showing the main part in a state in which the electronic element cover illustrated in Fig. 5(a) is attached.
Fig. 6(a) is a rear view showing a main part of the optical connector according to the embodiment of the invention and Fig. 6(b) is a B - B line sectional view in Fig. 2.
Fig. 7 is a perspective view showing a process for attaching the shield case from above an electronic component body according to the embodiment of the invention.
Fig. 8 is a perspective view showing the process for attaching the shield case from above the electronic component body according to the embodiment of the invention.
Fig. 9 is a sectional view showing an optical connector according to the related art.
Fig. 10(a) is a perspective view showing a shield case according to the related art and Fig. 10(b) is a sectional view showing the shield case according to the related art.

### <MODE FOR CARRYING OUT THE INVENTION>

An embodiment according to the invention will be described below with reference to the drawings.

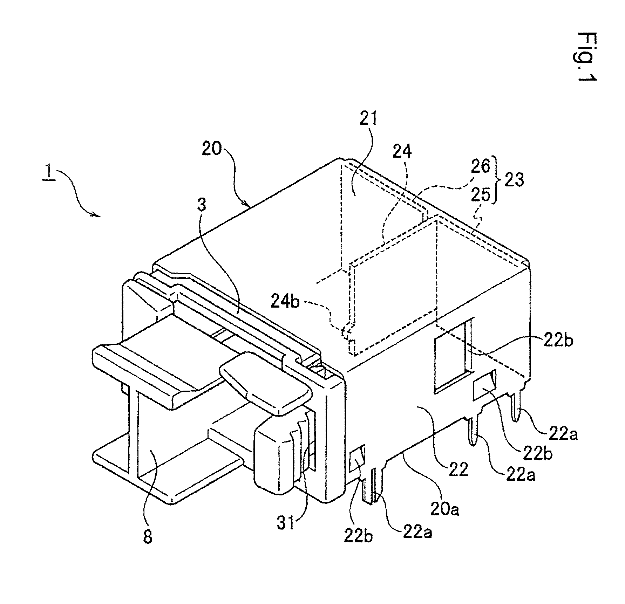

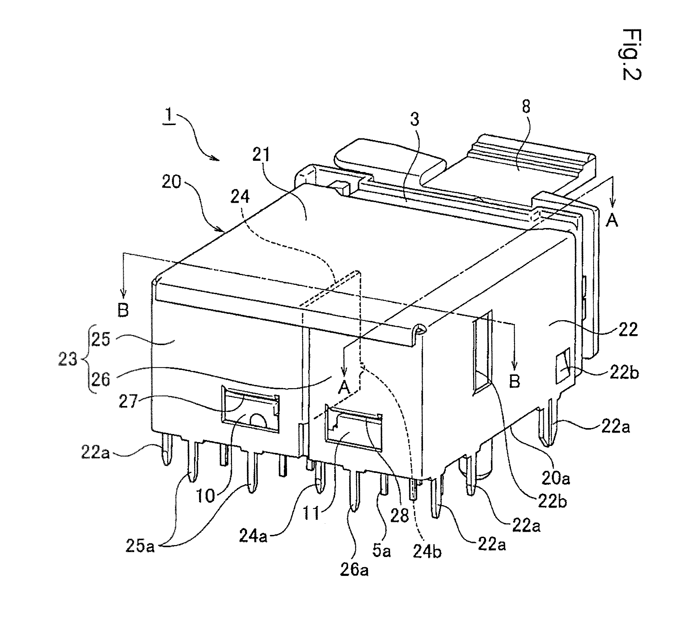

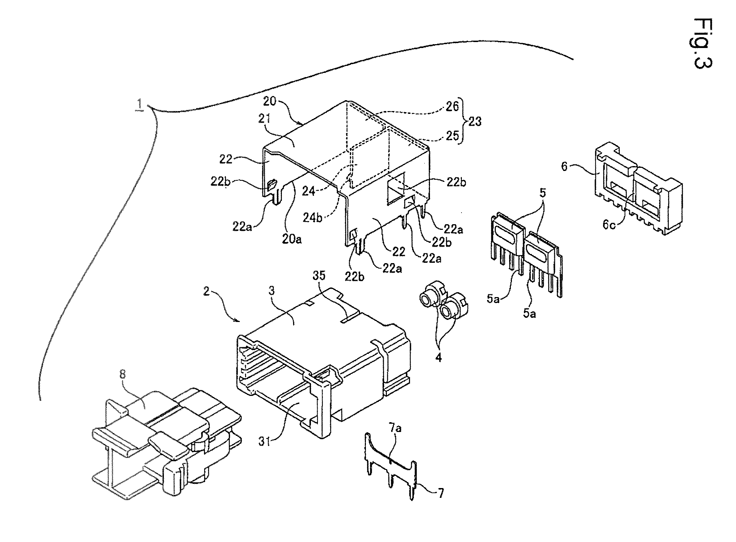

In Figs. 1 to 3, an optical connector 1 to be an electronic component includes an electronic component body 2 and a shield case 20 for covering an outer periphery of the electronic component body 2.

The electronic component body 2 includes a housing 3, a pair of lenses 4, a pair of optical transceivers (FOT : Fiber Optical transceiver) 5 to be electronic elements, an electronic element cover 6, and an option pin 7.

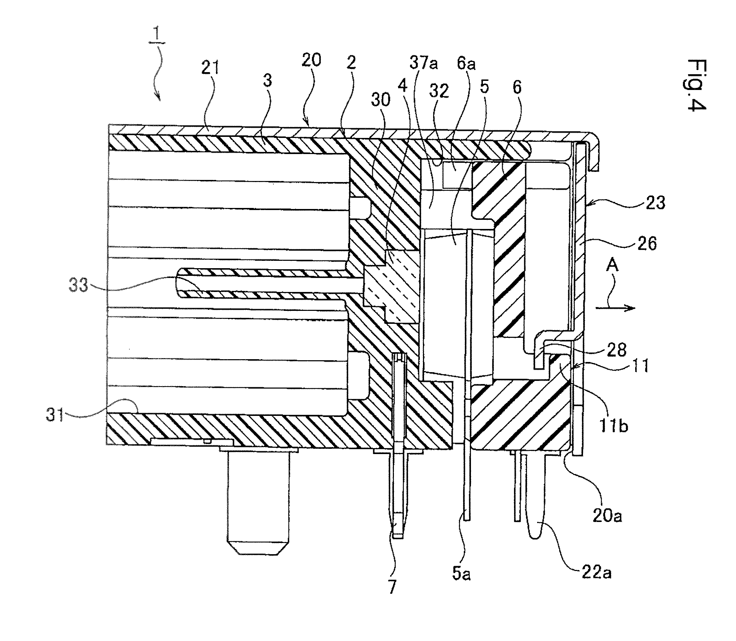

As shown in Fig. 4, the housing 3 has a partition wall 30 therein. A connector fitting chamber 31 and a component housing chamber 32 are provided in the housing 3 with the partition wall 30 set to be a boundary. A partner side connector (not shown) is fitted in the connector fitting chamber 31. Figs. 1 to 3 show a state in which a dust cap 8 is attached to the connector fitting chamber 31. The dust cap 8 is used for preventing dust or the like from entering the connector fitting chamber 31 in non-attachment of the partner connector (not shown).

A pair of cylindrical optical fiber positioning portions 33 is protruded from the partition wall 30 toward the connector fitting chamber 31. When the partner side connector (not shown) is fitted, tip parts of a pair of optical fibers (not shown) in the partner side connector (not shown) are positioned by the respective optical fiber positioning portions 33. The component housing chamber 32 is caused to penetrate through an inner part of each of the optical fiber positioning portions 33.

A pin push-in slit 34 (not shown) is provided on a bottom part at the component housing chamber 32 side from the partition wall 30 of the housing 3. The pin push-in slit (not shown) is formed on a bottom surface of the component housing chamber 32. A center slit 35 is provided on an upper wall portion at the component housing chamber 32 side from the partition wall 30 of the housing 3. The center slit 35 is formed on an upper surface of the component housing chamber 32.

The pair of lenses 4 is disposed on the component housing chamber 32 to face openings of the respective optical fiber positioning portions 33. The pair of lenses 4 is disposed in parallel with at least a position on an extended line of the center slit 35 on the housing 3 left.

The pair of optical transceivers 5 is disposed on the component housing chamber 32 in rear end positions of the respective lenses 4. One of the optical transceivers 5 is a light emitting device and the other is a light receiving device, for example. Each of the optical transceivers 5 has a plurality of lead portions 5a protruded downward. The respective lead portions 5a are connected to corresponding conductor portions of a mounting substrate (not shown) by soldering or the like. The pair of optical transceivers 5 is disposed in parallel with at least the position on the extended line of the center slit 35 on the housing 3 left.

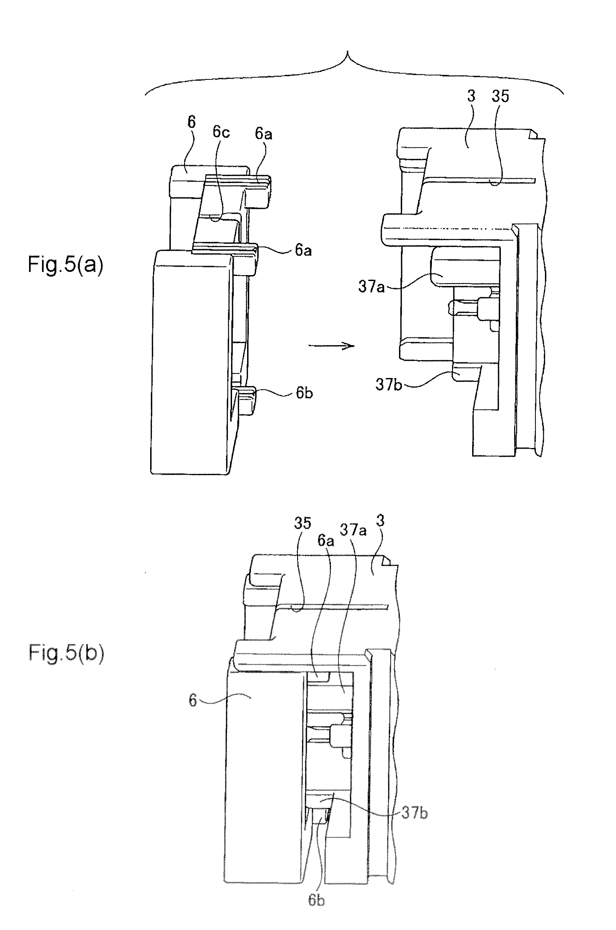

The electronic element cover 6 is disposed on both rear surfaces of the pair of optical transceivers 5. As shown in Fig. 5, the electronic element cover 6 has holding wall portions 6a and 6b in upper and lower positions. The electronic element cover 6 holds upper and lower protruded walls 37a and 37b of the housing 3 through the holding wall portions 6a and 6b in the upper and lower positions and is thus fixed to the housing 3. The pair of optical transceivers 5 is fixed to the housing 3 through the electronic element cover 6. A cover side slit 6c is provided in a central position of the electronic element cover 6. Although the cover side slit 6c is opened on an upper end surface of the electronic element cover 6 and is extended vertically in a downward direction, it does not reach a lower end surface. The cover side slit 6c is positioned on the extended line of the center slit 35 in the housing 3. In other words, a partition case portion 24 in the shield case 20 which will be described below is disposed by utilizing the center slit 35 of the housing 3 and a space on the extended line.

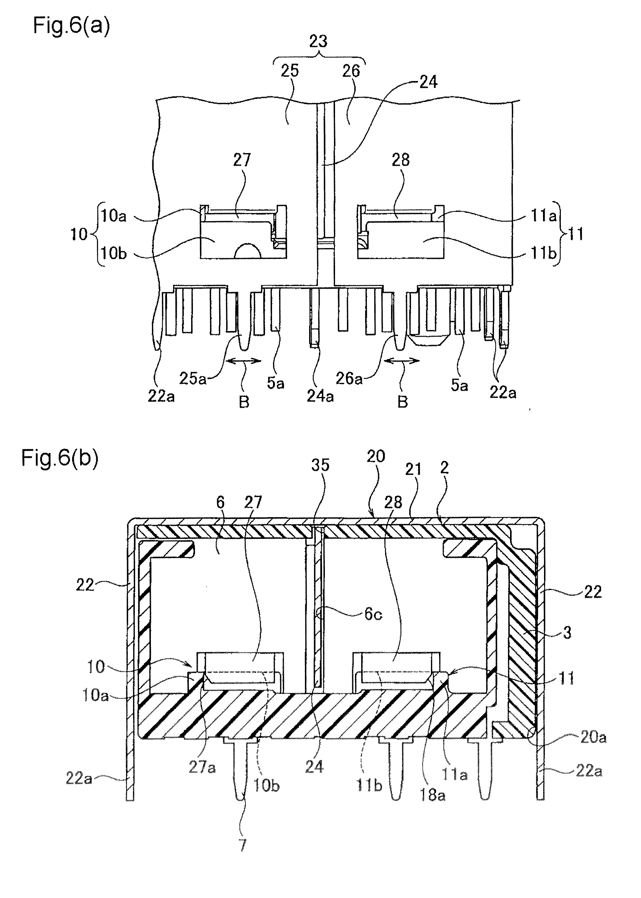

Position controlling portions 10 and 11 are provided on rear surfaces of the electronic element covers 6 respectively as shown in detail in Figs. 6 to 8. The position controlling portion 10 on a left side seen from a back is constituted by a left side wall portion 10a and a rear wall portion 10b which are protruded upward to take an L shape seen on an upper surface. The position controlling portion 11 on a right side seen from a back is constituted by a right side wall portion 11a and a rear wall portion 11b which are protruded upward to take an inverted L shape seen from an upper surface.

The option pin 7 is an option member to be assembled if necessary. The option pin 7 is formed by a conductive metal plate. The option pin 7 has an engaging hole 7a. The option pin 7 is pushed into a pin push-in slit (not shown) of the housing 3. The engaging hole 7a is engaged with an engaging protruded portion 24b of the shield case 20 so that the option pin 7 is conducted to the shield case 20. Each pin portion of the option pin 7 is connected to a grounding conductor portion of the mounting substrate (not shown) by soldering or the like.

The shield case 20 is formed by punching and bending a conductive metal plate. The shield case 20 is almost box-shaped in which a lower surface is set to be a case opening 20a. The shield case 20 has an upper surface case portion 21, left and right side surface case portions 22 and a rear surface case portion 23, and furthermore, includes a partition case portion 24 disposed to divide a rear part of an inner portion through a center. The rear surface case portion 23 is constituted by two divided case piece portions 25 and 26. The partition case portion 24 is formed by bending from an end surface at a central side of at least one of the two divided case piece portions 25 and 26. A tip surface of the partition case portion 24 is provided with the engaging protruded portion 24b.

Ground pins 22a, 24a, 25a and 26a to be grounding connection portions are protruded downward at lower ends of the respective side surface case portions 22, the partition case portion 24, and the respective divided case piece portions 25 and 26. The respective ground pins 22a, 24a, 25a and 26a are connected to the grounding conductor portion of the mounting substrate (not shown) by soldering or the like.

An engaging click 22b is provided on the left and right side surface case portions 22 by inward bending, respectively. Each engaging click 22b is engaged with the housing 3. Consequently, the shield case 20 is not removed from the electronic component body 2.

Position controlled portions 27 and 28 are provided on the divided case piece portions 25 and 26 by the inward bending, respectively. A taper surface 27a is formed on a left end in a tip portion of the position controlled portion 27 at a left side (see Fig. 6(b)). A taper surface 28a is formed on a right end of a tip portion of the position controlled portion 28 at a right side (see Fig. 6(b)). As shown in Figs. 4, 6(a) and 6(b), the left and right position controlled portions 27 and 28 are engaged with the left and right position controlling portions 10 and 11 of the electronic element cover 6, respectively.

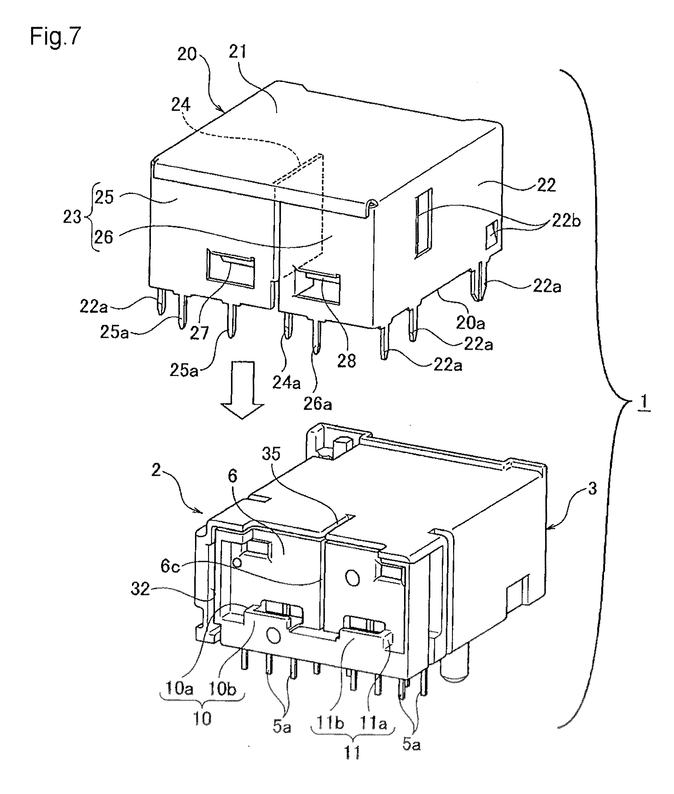

Next, description will be given to a work for attaching the shield case 20. As shown in Fig. 7, the shield case 20 is put on the electronic component body 2 from the case opening 20a side. Consequently, both of the side surface case portions 22 and the rear surface case portion 23 of the shield case 20 gradually cover the outer periphery of the electronic component body 2, and furthermore, the partition case portion 24 enters the component housing chamber 32 through the center slit 35 of the housing 3. When the covering is performed to reach a position in which the upper surface case portion 21 of the shield case 20 abuts on the upper surface of the electronic component body 2, each engaging click 22b is engaged with the housing 3. Moreover, a lower end surface of the partition case portion 24 enters a close part to a lower end of the cover side slit 6c of the electronic element cover 6 so that the partition case portion 24 partitions the pair of optical transceivers 5.

In the case in which the option pin 7 is attached, the option pin 7 is pushed in through the pin push-in slit (not shown) provided on a bottom part of the housing 3. When the option pin 7 is pushed into a push-in completing position, the engaging protruded portion 24b of the partition case portion 24 is engaged with the engaging hole 7a of the option pin 7. An upper part of the option pin 7 is disposed at the front of the respective optical transceivers 5.

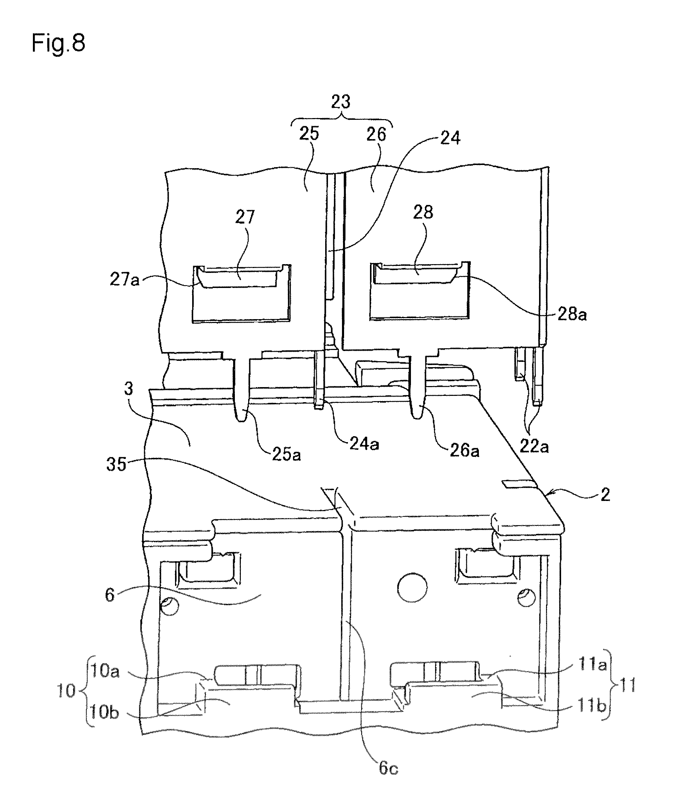

In the process for attaching the shield case 20, as shown in Fig. 8, the left and right position controlled portions 27 and 28 are engaged with the left and right position controlling portions 10 and 11 of the electronic element cover 6 respectively (see Figs. 4, 6(a) and 6(b)).

Even if the external force in the outward opening direction acts on the rear surface case portion 23 of the shield case 20 for some reason, a change in the position of the rear surface case portion 23 in the outward opening direction is blocked by the position controlled portions 27 and 28 of the shield case 20 and the rear wall portions 10b and 11 b of the position controlling portions 10 and 11. Therefore, the position of the shield case 20 is not changed in the outward opening direction (a direction of an arrow A in Fig. 4).

As shown in Fig. 6(b), the left side wall portion 10a and the right side wall portion 11a of the pair of position controlling portions 10 and 11 in the electronic element cover 6 collide with the position controlled portions 27 and 28, thereby controlling the change in the position of the rear surface case portion 23 of the shield case 20 in a transverse direction (a direction of an arrow B in Fig. 6(a)).

The rear surface case portion 23 is divided into two divided case piece portions 25 and 26. Therefore, the positions of the divided case piece portions 25 and 26 are easily changed in such a direction that they are separated from each other by the change in the position of the side surface case portion 22 in the outward opening direction. However, the divided case piece portion 25 on the left side is controlled toward a center by the position controlled portion 27 and the left side wall portion 10a at the left side and the divided case piece portion 26 on the right side is controlled toward the center by the position controlled portion 28 and the right side wall portion 11a at the right side. Therefore, the positions of the left and right divided case piece portions 25 and 26 are not changed in such a direction that they are separated from each other (in a transverse direction of the rear surface case portion 23 in Fig. 6(a)). As described above, it is possible to ensure precision in the positions of the ground pins 25a and 26a of the shield case 20. In the substrate mounting for the optical connector 1, accordingly, there is no fear that an interference with other components on the substrate (not shown) might not be caused. Thus, it is possible to carry out a smooth mounting work.

The taper surfaces 27a and 28a are provided in the tip portions of the position controlled portions 27 and 28 in such a direction that the position is easily changed. In the process for attaching the shield case 20, therefore, even if the position controlled portions 27 and 28 are placed in positions shifted from normal positions in such a direction that they are separated from each other, they are guided to the normal positions by the taper surfaces 27a and 28a. Therefore, the attaching work can smoothly be carried out.

The pair of optical transceivers 5 is divided by the partition case portion 24. Therefore, it is also possible to prevent a bad influence from being caused by mutual electromagnetic noises between the pair of optical transceivers 5.

Although the electronic component is the optical connector 1 in the embodiment, it is a matter of course that the invention can also be applied to an electronic component other than the optical connector 1.
Although the position controlling portion 10 on the left side is constituted by the left side wall portion 10a and the rear wall portion 10b which are protruded upward to take the L shape seen from the upper surface in the embodiment, moreover, a right side wall portion may be added to have a U-shaped structure seen from the upper surface. Although the position controlling portion 11 on the right side seen from a back is constituted by the right side wall portion 11a and the rear wall portion 11b which are protruded upward to take the inverted L shape seen from the upper surface, a left side wall portion may be added to have a U-shaped structure seen from the upper surface.

Although the electronic component according to the invention has been described above in detail with reference to the specific embodiment, the embodiment is only illustrative for the typical mode of the invention and the invention is not restricted to the embodiment. In other words, various changes can be made for enforcement without departing from the gist of the invention.

The application is based on Japanese Patent Application No. 2010-146285 filed on June 28, 2010 and the content is incorporated herein by reference.

### <INDUSTRIAL APPLICABILITY>

According to an electronic component of the invention, even if an external force in an outward opening direction acts on a shield case for some reason, a change in a position of the shield case in the outward opening direction is blocked by a position controlled portion of the shield case and a position controlling portion of an electronic component body. Therefore, the position of the shield case is not changed in the outward opening direction. Accordingly, it is possible to provide an electronic component having high precision in a position of a grounding connection portion of the shield case.

### <EXPLANATION OF DESIGNATION>

| | |
|---|---|
| 1 | optical connector (electronic component) |
| 2 | electronic component body |
| 3 | housing |
| 5 | optical transceiver (electronic element) |
| 6 | electronic component cover |
| 10, 11 | position controlling portion |
| 20 | shield case |
| 20a | case opening |
| 22a, 24a, 25a, 26a | ground pin (grounding connection portion) |
| 23 | rear surface case portion |
| 25, 26 | divided case piece portion |
| 27, 28 | position controlled portion |

## Claims

1. An electronic component, comprising:
an electronic component body; and
a shield case which is put on the electronic component body from a case opening side and is thus disposed on an outer periphery of the electronic component body, and has a grounding connection portion protruded downward from the case opening;
wherein the shield case is provided with a position controlled portion and the electronic component body is provided with a position controlling portion for controlling the position controlled portion into a proper position.

2. The electronic component according to claim 1, wherein the position controlling portion controls an outward opening direction of a surface of the shield case provided with the grounding connection portion and a transverse direction of the surface of the shield case provided with the grounding connection portion.

3. The electronic component according to claim 1 or 2, wherein one of the surfaces of the shield case is divided into a plurality of divided case piece portions and the divided case piece portions are provided with the grounding connection portion, and
the position controlled portion and the position controlling portion are disposed in the divided case piece portions provided with the grounding connection portion respectively.

4. The electronic component according to claim 1 or 2, wherein the electronic component body includes a housing, an electronic element, and an electronic element cover for attaching the electronic element to the housing, and
the electronic element cover is provided with the position controlling portion.

5. The electronic component according to claim 3, wherein the electronic component body includes a housing, an electronic element, and an electronic element cover for attaching the electronic element to the housing, and
the electronic element cover is provided with the position controlling portion.
